# EUROPEAN PATENT APPLICATION

(11) **EP 4 738 707 A1**
(43) Date of publication of application: **06.05.2026**
(21) Application number: 25169144.0
(22) Date of filing: 08.04.2025
(51) Int. Cl.: H03K 17/975, G06F 3/039

(54) **KNOB AND RELATED SENSING CIRCUIT**

(30) Priority: 30.10.2024 TW 113141498
(71) Applicant: Novatek Microelectronics Corp., HsinChu 300 (TW)
(72) Inventor: Tsai, Wu-Chuan, 302 Hsinchu County (TW)
(74) Representative: Straus, Alexander

(57) **Abstract**

A knob is disposed on a touch panel including a first touch sensor, a second touch sensor and a third touch sensor. The knob includes a bottom surface and a first connector. The bottom surface includes a sensing electrode aligned with the first touch sensor, a first common electrode aligned with the second touch sensor and receiving a first reference voltage from the second touch sensor, and a second common electrode aligned with the third touch sensor and receiving a second reference voltage from the third touch sensor. The first connector controls the sensing electrode to be conducted with the first common electrode and the second common electrode or not when the knob rotates. A touch sensing circuit of the touch panel determines a rotation direction of the knob according to a signal variation of the first touch sensor.

## Description

### Field of the Invention

The present invention relates to a knob sensing technique, and more particularly, to a sensing technique for a knob on a touch panel.

### Background of the Invention

Touch functions gradually become popular in vehicles' center information display (CID) systems. When environmental settings of a car (such as the temperature of air conditioning and the volume of car audio) need to be adjusted, the driver must focus more on the touch position and relevant settings displayed on the screen, thus affecting driving safety.

In order to improve driving safety, a knob on a touch panel may be applied in the CID system, where a physical knob is disposed on the touch screen. Therefore, the driver can easily adjust the settings by controlling the knob without being distracted by the displayed values.

### Summary of the Invention

The present invention therefore provides a knob on a touch panel and related sensing circuit, in order to improve the driving safety in vehicle applications.

This is achieved by a knob according to independent claim 1 or by a sensing circuit according to independent claim 13. The dependent claims pertain to corresponding further developments and improvements.

As will be seen more clearly from the detailed description following below, a knob, which is disposed on a touch panel comprising a first touch sensor, a second touch sensor and a third touch sensor, comprises a bottom surface and a first connector. The bottom surface comprises a sensing electrode, which is aligned with the first touch sensor; a first common electrode, which is aligned with the second touch sensor and receives a first reference voltage from the second touch sensor; and a second common electrode, which is aligned with the third touch sensor and receives a second reference voltage from the third touch sensor. The first connector controls the sensing electrode to be conducted with the first common electrode and the second common electrode or not when the knob rotates. A touch sensing circuit of the touch panel determines a rotation direction of the knob according to a signal variation of the first touch sensor.

In another aspect, a sensing circuit coupled to a knob comprises a receiving circuit and a processing circuit. The receiving circuit receives a signal variation from the knob. The processing circuit, coupled to the receiving circuit, determines a rotation direction of the knob according to the signal variation. The signal variation is received through a first touch sensor aligned with and coupled to a sensing electrode of the knob, and the signal variation is generated according to whether the sensing electrode is conducted with a first common electrode and a second common electrode in the knob.

### Brief Description of the Drawings

FIG. 1 is a schematic diagram of the bottom of a knob.
FIG. 2 is a schematic diagram of another knob.
FIG. 3 is a schematic diagram of a knob according to an embodiment of the present invention.
FIG. 4 illustrates the detailed structure of electrode rings of the sensing electrode and the common electrodes in a disassembled manner.
FIG. 5 and FIG. 6 illustrate the side view of the electrode ring arrangement in the knob shown in FIG. 3.
FIG. 7 is a schematic diagram of another knob according to an embodiment of the present invention.
FIG. 8 illustrates the detailed structure of electrode rings of the sensing electrode and the common electrodes in a disassembled manner.
FIG. 9 and FIG. 10 illustrate the side view of the electrode ring arrangement in the knob shown in FIG. 7.
FIGs. 11-14 illustrate the sensing systems in which the knob is in 4 different states, respectively.
FIG. 15 illustrates the correspondence of the equivalent capacitance and the sensing signal.
FIG. 16 is a schematic diagram of the rotation operation of the knob corresponding to different states.
FIG. 17 is a schematic diagram of the press operation of the knob corresponding to different states.
FIG. 18 illustrates the knob state determined according to the correspondence of the equivalent capacitance and the sensing signal with threshold values.
FIG. 19 is a schematic diagram of the signal distribution on the touch sensor corresponding to the sensing electrode according to an embodiment of the present invention.
FIG. 20 is a schematic diagram of a conductor of a knob according to an embodiment of the present invention.

### Detailed Description

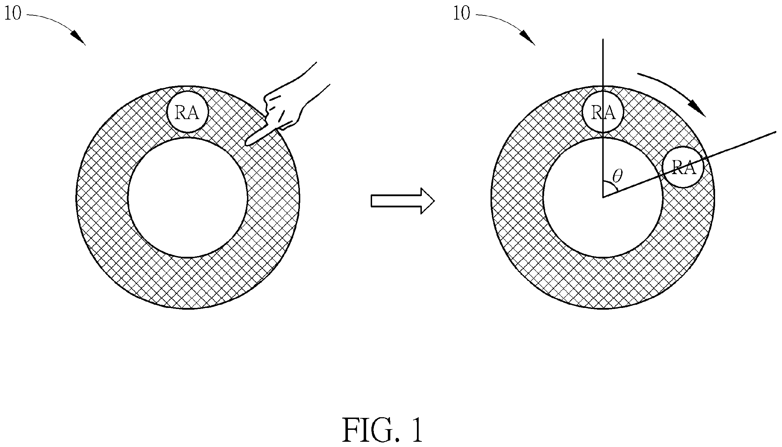

FIG. 1 is a schematic diagram of the bottom of a knob 10. As shown in FIG. 1, the knob 10 may be attached on a touch panel. The bottom of the knob 10 includes an electrode RA. The position of the electrode RA may change by turning the knob 10. When a user contacts the knob 10, the voltage of the electrode RA may become the ground level through the knob 10 and the user. When the sensing circuit of the touch panel senses that the user is turning the knob 10 through the touch electrodes on the touch panel, the sensing circuit may determine the rotation direction and angle θ of the knob 10 based on the sensed position of the electrode RA. More specifically, when the user touches the knob 10, the voltage level of the electrode RA changes, and a sensing signal is also sensed by the touch panel. At this time, the information of the sensing signal related to the position of the electrode RA may be sent to a back-end sensing circuit (e.g., the touch sensor chip for controlling the touch panel), which may determine the state of the knob 10 according to the distribution of the appeared sensing signals. For example, the sensing circuit may utilize an appropriate algorithm to analyze the sensing signals to determine the position of the electrode RA, so as to determine the rotation direction and angle θ of the knob 10.

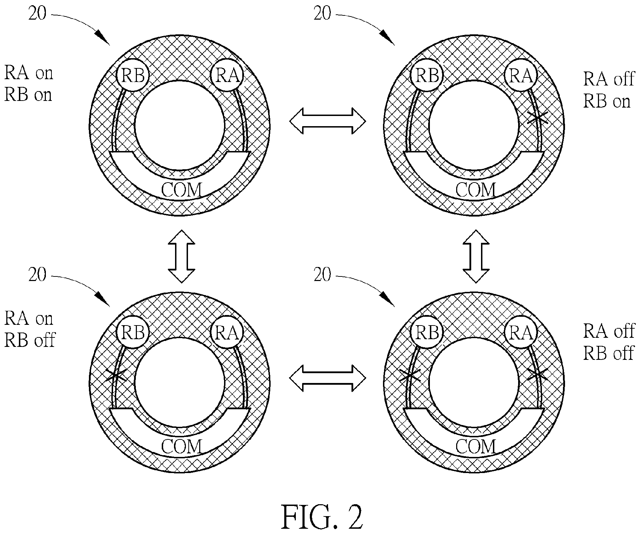

FIG. 2 is a schematic diagram of another knob 20. As shown in FIG. 2, the knob 20 includes sensing electrodes RA and RB and a common electrode COM. Based on the state of the knob 20, the sensing electrode RA may selectively be connected to (on) or disconnected from (off) the common electrode COM, and the sensing electrode RB may be selectively connected to or disconnected from the common electrode COM.

The knob 20 is attached on a touch panel. The touch panel has multiple touch sensing electrodes, where a touch sensor chip or touch with display driver integration (TDDI) circuit may apply a ground signal to a first touch sensing electrode corresponding to the common electrode COM. At this time, the common electrode COM may also sense the ground signal to make the voltage of the common electrode COM become the ground level. When the sensing electrode RA or RB is electrically connected to the common electrode COM, the voltage of the sensing electrode RA or RB may also become the ground level. At this time, a second touch sensing electrode corresponding to the sensing electrode RA or a third touch sensing electrode corresponding to the sensing electrode RB on the touch panel may also sense the ground level of the sensing electrode RA or RB; hence, the touch sensor chip or the TDDI circuit may detect the signals through the second touch sensing electrode or the third touch sensing electrode to determine the operations of the knob 20. It should be noted that the sensing electrode RA or RB or the common electrode COM may correspond to multiple second touch sensing electrodes, multiple third touch sensing electrodes or multiple first touch sensing electrodes.

In another embodiment, the sensing electrodes RA and RB may be connected to or disconnected from the common electrode COM during the rotation of the knob 20 through structural design, such as the shape or structure of the electrodes. Therefore, when the knob 20 is rotated, the connections between the sensing electrodes RA and RB and the common electrode COM may be modified. The back-end sensing circuit may thereby determine the state of the knob 20 according to the sensed signals. For example, in the upper left part of FIG. 2, the sensing electrodes RA and RB are both connected to the common electrode COM, and this is the first state of the knob 20. After the rotations of the knob 20, the electrical connection between the sensing electrode RA and the common electrode COM is disconnected, while the sensing electrode RB and the common electrode COM are still electrically connected, as shown in the upper right part of FIG. 2, and this is the second state of the knob 20. After the knob 20 further rotates, the electrical connection between the sensing electrode RB and the common electrode COM is disconnected, while the sensing electrode RA and the common electrode COM are electrically connected, as shown in the lower left part of FIG. 2, and this is the third state of the knob 20. After the knob 20 further rotates, the electrical connections between the sensing electrodes RA and RB and the common electrode COM are both disconnected, as shown in the lower right part of FIG. 2, and this is the fourth state of the knob 20. The above four states may be detected by the touch sensor chip or the TDDI circuit of the touch panel.

In such a situation, the touch sensor chip may determine whether the knob 20 is rotating clockwise or counterclockwise according to continuous state changes of the knob 20 (i.e., the changes of electrical connections between these electrodes).

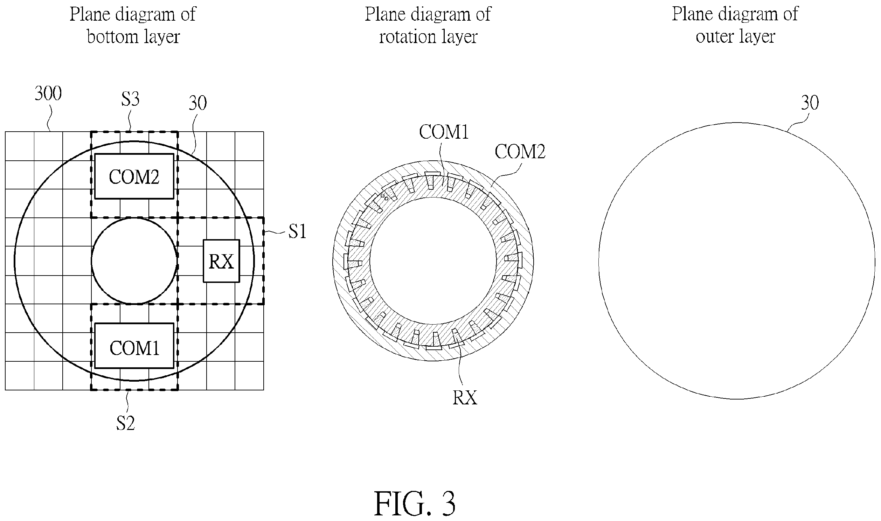

FIG. 3 is a schematic diagram of a knob 30 according to an embodiment of the present invention, where the plane diagrams at several positions are shown. The knob 30 includes a sensing electrode RX and two common electrodes COM1 and COM2. According to the rotation of the knob 30, the common electrodes COM1 and COM2 may be controlled to be electrically connected to the sensing electrode RX or not under different states, to generate different sensing signal amounts.

As the plane diagram of the bottom layer shown in the left side of FIG. 3, the knob 30 may be deployed on a touch panel 300, where each grid refers to a touch sensor on the touch panel 300. This touch sensor may represent a touch sensing electrode, which is the minimum unit for performing touch sensing on the touch panel 300. In an embodiment, the touch sensing electrode may serve as a common electrode during a display period of the touch panel 300, and serve as a touch sensing electrode during a touch period. In another embodiment, the touch panel 300 is an organic light emitting diode (OLED) touch panel, and thus the touch sensing electrode may not be operated as a common electrode during the display period as in the liquid crystal display (LCD) panel. The touch sensor chip of the touch panel or the sensing circuit included in the touch sensor chip may determine whether there is a touch or whether the sensing electrode RX of the knob 30 is sensed according to the capacitance variations on the touch sensor.

As shown in FIG. 3, the sensing electrode RX and the common electrodes COM1 and COM2 may be respectively fixed on multiple touch sensors and aligned with these touch sensors. In another embodiment, the sensing electrode RX and/or the common electrodes COM1 and COM2 may be located on only one touch sensor, and thus within the sensing range of only one touch sensor.

In an embodiment, the sensing circuit may apply a specific voltage to the touch sensors under the common electrodes COM1 and COM2, where the specific voltage may be a ground voltage. In another embodiment, the sensing circuit may apply different reference voltages to the touch sensors under the common electrodes COM1 and COM2. For example, as shown in FIG. 3, the touch sensor under the sensing electrode RX is a first touch sensor S1, the touch sensor under the common electrode COM1 is a second touch sensor S2, and the touch sensor under the common electrode COM2 is a third touch sensor S3. The sensing circuit may apply the ground voltage to the second touch sensor S2 and apply a negative voltage to the third touch sensor S3. By applying different voltages to the second touch sensor S2 or the third touch sensor S3, the sensing circuit will let the capacitance variations (or referred to as signal amounts or signal variations) sensed by the first touch sensor S1 to have more evident differences.

When the knob is rotating, the sensing electrode RX may be respectively electrically connected, or simultaneously electrically connected, or not electrically connected to the common electrodes COM1 and COM2. The sensing circuit applies a driving signal to the first touch sensor S1 under the sensing electrode RX and receives a sensing signal from the first touch sensor S1. The sensing circuit may determine the connecting state of the sensing electrode RX and the common electrodes COM1 and COM2 at this time according to the signal amount of the sensed signal, and determine the knob operations according to the signal amount of the continuously read signals.

In various embodiments of the present invention, through the structural design inside the knob 30, the state of whether the common electrode COM1 or COM2 is electrically connected to the sensing electrode RX may change during rotation of the knob 30, so that the sensing circuit may determine the rotation direction and angle of the knob 30 according to the sensed signal amount of the sensing electrode RX. As the plane diagram of the rotation layer shown in the middle of FIG. 3, the sensing electrode RX and the common electrodes COM1 and COM2 are respectively coupled to a corresponding electrode ring, where the electrode ring of the common electrode COM1 is located inside the electrode ring of the sensing electrode RX, and the electrode ring of the common electrode COM2 is located outside the electrode ring of the sensing electrode RX. The electrode rings of the common electrodes COM1 and COM2 are provided with a sawtooth structure. When the knob 30 rotates, the electrode rings of the common electrodes COM1 and COM2 will rotate accordingly, so that the protruding part of the sawtooth shape contacts the electrode ring of the sensing electrode RX when the knob 30 rotates to several angles, thereby making the common electrode COM1 or COM2 and the sensing electrode RX electrically connected to each other.

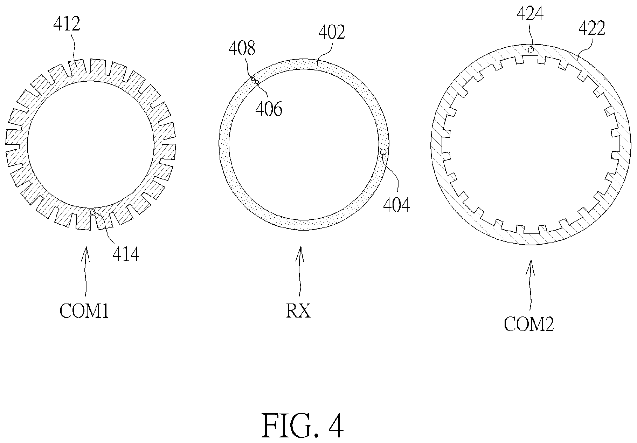

FIG. 4 illustrates the detailed structure of the electrode rings of the sensing electrode RX and the common electrodes COM1 and COM2 in a disassembled manner. The sensing electrode RX is coupled to a sensing electrode ring 402, and an electrode post 404 and connecting posts 406 and 408 are deployed on the sensing electrode ring 402. The common electrode COM1 is coupled to a common electrode ring 412 and an electrode post 414. The common electrode COM2 is also coupled to a common electrode ring 422 and an electrode post 424. Referring to FIG. 4 along with FIG. 3, the electrode post 404 is disposed above the sensing electrode RX on the touch panel 300 and connected between the sensing electrode RX on the touch panel 300 and the sensing electrode ring 402, so that the sensing electrode RX and the sensing electrode ring 402 are electrically connected to each other through the electrode post 404. Similarly, the electrode post 414 is disposed above the common electrode COM1 on the touch panel 300 and connected between the common electrode COM1 on the touch panel 300 and the common electrode ring 412, so that the common electrode COM1 and the common electrode ring 412 are electrically connected to each other through the electrode post 414. The electrode post 424 is disposed above the common electrode COM2 on the touch panel 300 and connected between the common electrode COM2 on the touch panel 300 and the common electrode ring 422, so that the common electrode COM2 and the common electrode ring 422 are electrically connected to each other through the electrode post 424. Note that in the present invention, the sensing electrode ring 402, the electrode post 404 and the connecting posts 406 and 408 may be regarded as conductive elements coupled to the sensing electrode RX, or may be regarded as parts of the sensing electrode RX. Similarly, the common electrode ring 412 and the electrode post 414 may be regarded as conductive elements coupled to the common electrode COM1, or may be regarded as parts of the common electrode COM1. The common electrode ring 422 and the electrode post 424 may be regarded as conductive elements coupled to the common electrode COM2, or may be regarded as parts of the common electrode COM2.

In addition, the connecting post 406 may be a conductor protruding from the sensing electrode ring 402 toward the common electrode COM1, and the connecting post 406 and the sensing electrode ring 402 are electrically connected to each other. Correspondingly, the common electrode ring 412 of the common electrode COM1 has a sawtooth structure. When the knob 30 rotates to several angles, the connecting post 406 may contact the sawtooth protruding part on the common electrode ring 412, so that the common electrode ring 412 is electrically connected to the sensing electrode ring 402, and therefore the common electrode COM1 is electrically connected to the sensing electrode RX. When the knob 30 rotates to other angles, the position of the connecting post 406 is aligned with the sawtooth recessing part on the common electrode ring 412, and thus the connecting post 406 does not contact the common electrode ring 412, so that the common electrode ring 412 is not electrically connected to the sensing electrode ring 402, and thus there is no electrical connection between the common electrode COM1 and the sensing electrode RX.

Similarly, the connecting post 408 may be a conductor protruding from the sensing electrode ring 402 toward the common electrode COM2, and the connecting post 408 and the sensing electrode ring 402 are electrically connected to each other. Correspondingly, the common electrode ring 422 of the common electrode COM2 has a sawtooth structure. When the knob 30 rotates to several angles, the connecting post 408 may contact the sawtooth protruding part on the common electrode ring 422, so that the common electrode ring 422 is electrically connected to the sensing electrode ring 402, and therefore the common electrode COM2 is electrically connected to the sensing electrode RX. When the knob 30 rotates to other angles, the position of the connecting post 408 is aligned with the sawtooth recessing part on the common electrode ring 422, and thus the connecting post 408 does not contact the common electrode ring 422, so that the common electrode ring 422 is not electrically connected to the sensing electrode ring 402, and thus there is no electrical connection between the common electrode COM2 and the sensing electrode RX.

In an embodiment, when the knob 30 rotates, the sensing electrode ring 402 is fixed, and the common electrode rings 412 and 422 rotate with the knob 30. In such a situation, the positions of the connecting posts 406 and 408 on the sensing electrode ring 402 are fixed. With the rotation of the common electrode rings 412 and 422, the protruding part and the recessing part of a sawtooth sequentially overlap the positions of the connecting posts 406 and 408, so as to change the contact state between the common electrode rings 412 and 422 and the corresponding connecting posts 406 and 408, thereby changing the electrical connection state between the common electrodes COM1 and COM2 and the sensing electrode RX. In such a situation, the signal amount of the touch sensor under the sensing electrode RX may change. The back-end sensing circuit (such as the sensing circuit in the touch sensor chip of the touch panel) may thereby determine the rotation direction and angle of the knob 30 accordingly.

In another embodiment, when the knob 30 rotates, the common electrode rings 412 and 422 are fixed; instead, the sensing electrode ring 402 rotates with the knob 30. In such a situation, the positions of the connecting posts 406 and 408 on the sensing electrode ring 402 continuously change during the rotation of the knob 30, while the position of the sawtooth on the common electrode rings 412 and 422 keeps unchanged. This may also change the contact state between the common electrode rings 412 and 422 and the corresponding connecting posts 406 and 408, so as to realize the determination of the knob 30 rotation.

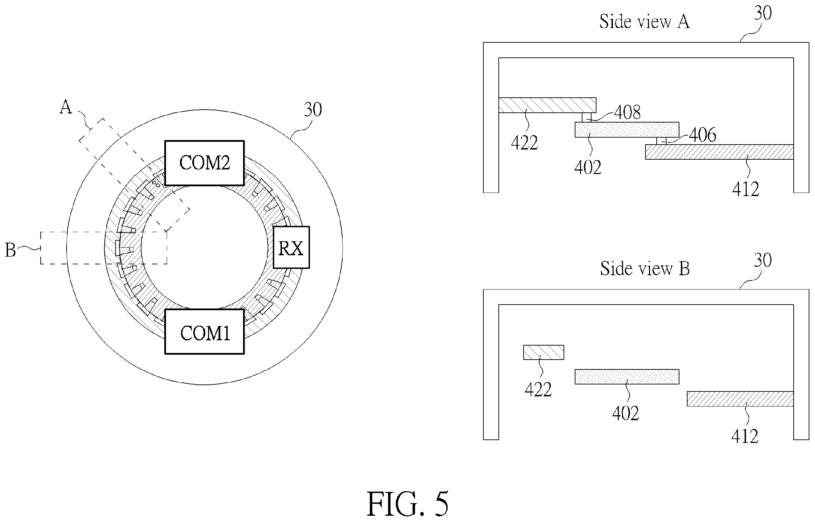

In order to illustrate the structure of the knob of the present invention more clearly, FIG. 5 further illustrates a side view of the electrode ring arrangement in the knob 30, where the cross-sections of positions A and B are shown. Position A is a position where the connecting posts 406 and 408 are located. In this embodiment, the state of the knob 30 is that the sawtooth protruding parts of the common electrode rings 412 and 422 both rotate to the positions of the connecting posts 406 and 408; hence, the common electrode rings 412 and 422 are in contact with the connecting posts 406 and 408 respectively, causing the conducted/electrically connected state. Position B is a position without the connecting posts 406 and 408, where the common electrode rings 412 and 422 are in the sawtooth recessing part, which is shorter and would not overlap the sensing electrode ring 402; hence, the common electrode rings 412 and 422 do not contact the connecting posts 406 and 408.

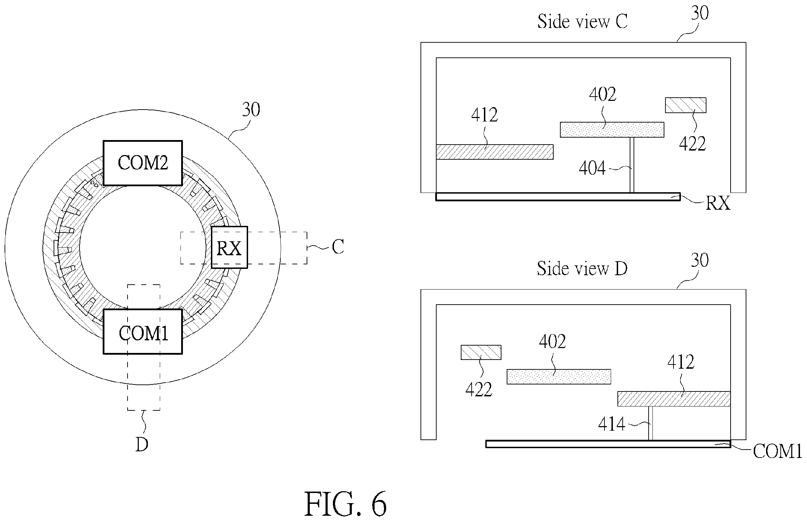

FIG. 6 shows the cross-sections of other positions C and D. Position C is a position of the sensing electrode RX on the panel. As can be seen from the corresponding side view, the sensing electrode ring 402 is electrically connected to the sensing electrode RX through the electrode post 404. Position D is a position of the common electrode COM1 on the panel. As can be seen from the corresponding side view, the common electrode ring 412 is electrically connected to the common electrode COM1 through the electrode post 414.

As can be seen, the knob 30 of the present invention includes only one sensing electrode RX. As for the back-end sensing circuit, the sensing signal used to determine the knob operation only needs to be received through one sensing electrode RX. More specifically, the sensing circuit only needs to receive the sensing signal from the touch sensor under the sensing electrode RX, where the signals from other positions need not to be considered. In addition, the sensing circuit does not need to receive sensing signals corresponding to multiple sensing electrodes to perform more complex comparison and determination. In such a situation, the sensing circuit only requires one receiving channel. This may simplify the structure and operation of the receiving end of the sensing circuit, thereby reducing the costs.

Note that the structure of the knob 30 shown in FIGs. 3-6 as illustrated above is one of various implementations of the present invention. In other embodiments, different numbers of common electrodes may be used to achieve more flexible determination of signal amount variations. In an embodiment, an additional common electrode may be included to realize the press detection of the knob.

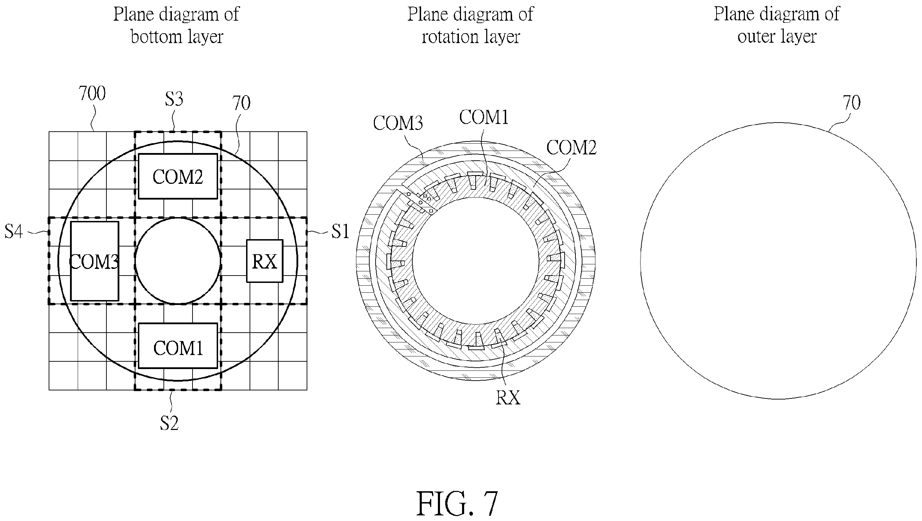

FIG. 7 is a schematic diagram of another knob 70 according to an embodiment of the present invention. The structure of the knob 70 is similar to the structure of the knob 30 shown in FIG. 3, so elements having similar functions are denoted by the same symbol. As shown in FIG. 7, the difference between the knob 70 and the knob 30 is that the knob 70 further includes a common electrode COM3. This common electrode COM3 is configured to realize the pressing function. More specifically, according to whether the common electrode COM3 (and other common electrodes COM1 and COM2) is electrically connected to the sensing electrode RX, the back-end sensing circuit may determine whether the knob 70 is pressed. Similarly, the knob 70 is disposed on a touch panel 700, and the common electrode COM3 may be disposed above one or more touch sensors of the touch panel 700 (i.e., the fourth touch sensor S4 shown in FIG. 7). Therefore, by applying the same or different reference voltages to the fourth touch sensor S4, whether the common electrode COM3 and the sensing electrode RX are electrically connected may be determined based on the signal amount sensed by the first touch sensor S1.

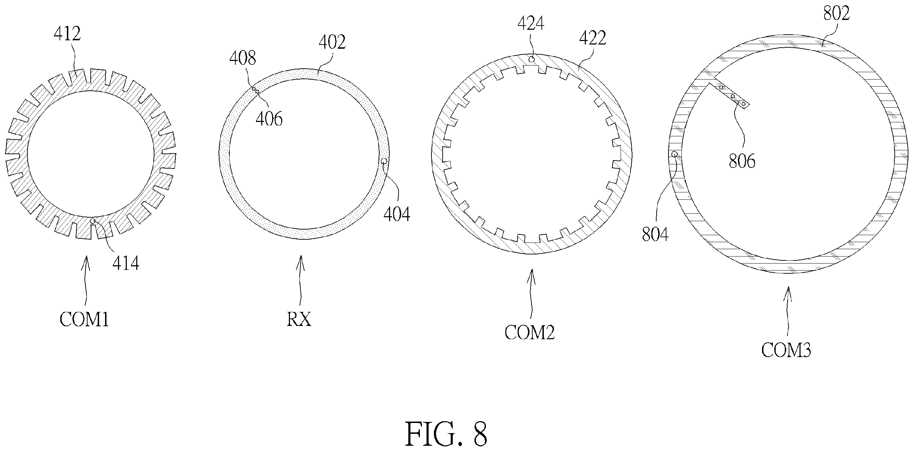

FIG. 8 illustrates the detailed structure of the electrode rings of the sensing electrode RX and the common electrodes COM1, COM2 and COM3 in a disassembled manner. The electrode rings and electrode posts of the sensing electrode RX and the common electrodes COM1 and COM2 are deployed in the same manner as in FIG. 4, and will not be narrated herein. The common electrode COM3 is coupled to a common electrode ring 802, an electrode post 804 and a connector 806. Referring to FIG. 8 along with FIG. 7, the electrode post 804 is disposed above the common electrode COM3 on the touch panel 300 and connected between the common electrode COM3 on the touch panel 300 and the common electrode ring 802, so that the common electrode COM3 and the common electrode ring 802 are electrically connected to each other through the electrode post 804. Note that in the present embodiment, the common electrode ring 802, the electrode post 804 and the connector 806 may be regarded as conductive elements coupled to the common electrode COM3, or may be regarded as parts of the common electrode COM3.

In addition, the common electrode ring 802 is located at the outermost side of all electrode rings. The connector 806, which may be a conductor extending inwardly from the common electrode ring 802, is electrically connected to the common electrode ring 802, and may extend to overlap the innermost common electrode ring 412. Therefore, when the knob 70 is pressed, the connector 806 may contact the sensing electrode ring 402 and the common electrode rings 412 and 422, so that the common electrode COM3 is electrically connected to the sensing electrode RX and the common electrodes COM1 and COM2.

It should be noted that the common electrode ring 802 of the common electrode COM3 may be designed to be stationary when the knob 70 rotates, or may be designed to rotate with the knob 70 according to system requirements. As long as the pressing operation of the knob 70 may change the electrical connection relationship between the common electrode COM3 and the sensing electrode RX, thereby changing the signal amount generated by the sensing electrode RX, the related implementations should fall within the scope of the present invention.

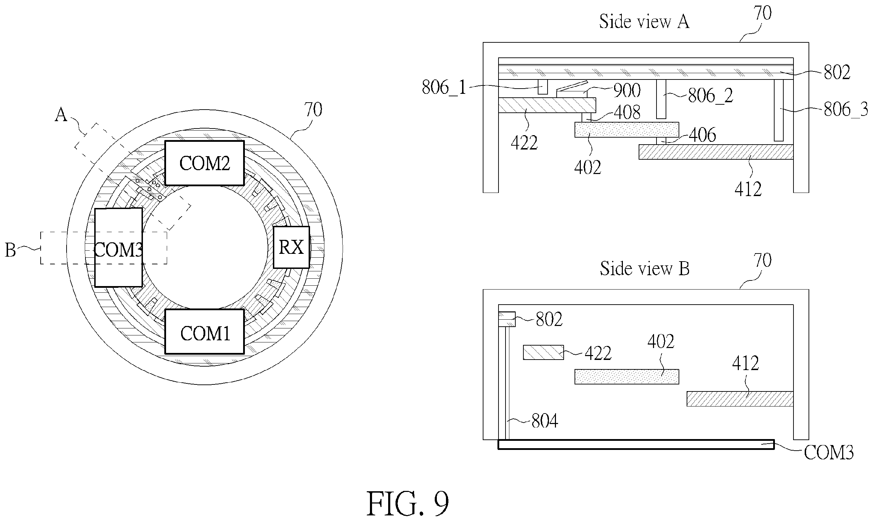

In order to illustrate the structure of the knob 70 and the operation of the common electrode COM3 more clearly, FIG. 9 further illustrates a side view of the electrode ring arrangement in the knob 70, where the cross-sections of positions A and B are shown. In addition to having the connecting posts 406 and 408, position A is also a position where the connector 806 of the common electrode ring 802 is located. It can be seen from the side view corresponding to position A that the connector 806 extends above the electrode rings 422, 402 and 412, and vertical connecting posts 806_1, 806_2 and 806_3 are disposed above each electrode ring. The connecting posts 806_1, 806_2 and 806_3 may be regarded as conductive elements coupled to the connector 806, or may be regarded as parts of the connector 806.

As shown in FIG. 9, the knob 70 includes a pressing clip 900, which is disposed between the common electrode rings 802 and 422. When the knob 70 is not pressed, the pressing clip 900 may push the common electrode ring 802 to a higher position, so that there are small gaps between the connecting posts 806_1, 806_2 and 806_3 and the electrode rings 422, 402 and 412, respectively, and they are not conducted with each other. At this time, the common electrode COM3 is not electrically connected to the sensing electrode RX and other common electrodes COM1 and COM2. When the knob 70 is pressed, the common electrode ring 802 and the connecting posts 806_1, 806_2 and 806_3 move downwards to contact the corresponding electrode rings 422, 402 and 412, respectively, so that the common electrode COM3 is electrically connected to all of the sensing electrode RX and other common electrodes COM1 and COM2. In such a situation, the sensing electrode RX may receive signals from the common electrodes COM1-COM3, so the back-end sensing circuit may determine that the knob 70 is pressed accordingly.

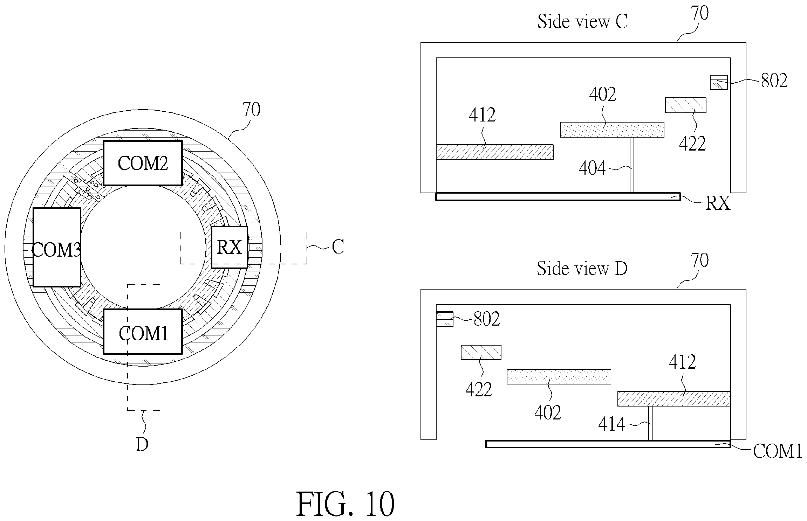

FIG. 9 also illustrates the cross-section of position B. Position B is a position of the common electrode COM3 on the panel. As can be seen from the corresponding side view, the common electrode ring 802 is electrically connected to the common electrode COM3 through the electrode post 804. FIG. 10 further illustrates the cross-sections of other positions C and D in the knob 70, which correspond to the positions of the sensing electrode RX and the common electrode COM1 on the panel, respectively. Their detailed structures are similar to those shown in FIG. 6, and will not be narrated herein.

Based on the structure of the knob 70 as described above, the sensing electrode RX may be electrically connected to different numbers of common electrodes COM1-COM3 under different rotational states or pressing states, so as to generate different levels of signal amounts in the touch sensor under the sensing electrode RX. Therefore, the sensing circuit may determine the state of the knob 70 by detecting the signal amount of the touch sensor(s), so as to determine the rotation direction and angle of the knob 70 and also realize the determination of press.

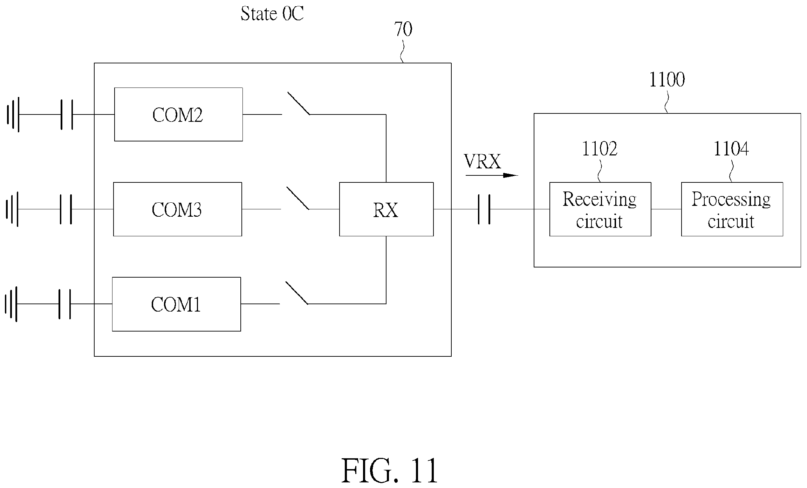

In an embodiment, the knob 70 is configured to have 4 different states. FIGs. 11-14 illustrate the sensing system in which the knob 70 is in these 4 different states, respectively. The sensing system includes the knob 70 and a sensing circuit 1100 used to detect the knob 70. In an embodiment, the knob 70 may be disposed on a touch panel, and the sensing circuit 1100 may be used for controlling/driving the touch panel and detecting the operation of the knob 70. In an embodiment, the sensing circuit 1100 may be an integrated circuit (IC) disposed in a chip. It may be connected to the touch sensors on the touch panel corresponding to the electrodes of the knob 70 through one or more pins of the chip, for performing detection of the knob 70.

In detail, the sensing circuit 1100 includes a receiving circuit 1102 and a processing circuit 1104. The receiving circuit 1102 is used for receiving a sensing signal VRX from the knob 70. More specifically, the sensing signal VRX received by the receiving circuit 1102 comes from the touch sensor(s) corresponding to the sensing electrode RX, such as the one or more touch sensors under the sensing electrode RX (i.e., the first touch sensor S1 in the above embodiment). In an embodiment, the receiving circuit 1102 may output a driving signal to the touch sensor(s) under the sensing electrode RX, to correspondingly receive the sensing signal VRX from the touch sensor(s). The processing circuit 1104, which is coupled to the receiving circuit 1102, may determine the state of the knob 70 according to the signal amount of the sensing signal VRX. For example, the processing circuit 1104 contains an algorithm, which may be used to determine which state the knob 70 is in (such as which angle it rotates to or whether it is pressed) based on the signal distribution of the touch sensor under the sensing electrode RX.

In addition, the sensing circuit 1100 may also include a driving circuit (not illustrated), which may apply a reference voltage (e.g., a ground voltage) to the touch sensors corresponding to the common electrodes COM1-COM3 (such as the touch sensors under the common electrodes COM1-COM3) when detecting the knob 70. This reference voltage may be coupled to the common electrodes COM1-COM3. Depending on whether each of the common electrodes COM1-COM3 is electrically connected to the sensing electrode RX, signals with different magnitudes may be generated on the sensing electrode RX. These signals are then coupled to the touch sensor under the sensing electrode RX through the parasitic capacitance between the knob 70 and the panel, thereby generating the sensing signal VRX that may be detected by the sensing circuit 1100.

Referring to FIGs. 7 and 9 along with FIGs. 11-14, in the structural design of the knob 70, the common electrodes COM1 and COM2 are used to perform rotation detection. When the knob 70 rotates to different angles, there may be different numbers of common electrodes COM1 and COM2 electrically connected to the sensing electrode RX, so as to generate different signal amounts on the touch sensor under the sensing electrode RX, where the signal amounts correspond to different magnitudes of the sensing signal VRX. The common electrode COM3 is used to perform pressing detection. As shown in FIG. 9, when the knob 70 is pressed, the common electrodes COM1-COM3 are all electrically connected to the sensing electrode RX, thereby generating a larger signal amount on the touch sensor under the sensing electrode RX.

As mentioned above, the knob 70 is configured to have 4 different states, which are denoted by 0C, 1C, 2C and 3C, respectively. FIG. 11 illustrates the state 0C. The state 0C means that when the knob 70 rotates to a specific angle, neither the common electrode COM1 nor the common electrode COM2 is electrically connected to the sensing electrode RX. At this time, the knob 70 is not pressed, so the common electrode COM3 is not electrically connected to the sensing electrode RX either. In such a situation, the sensing electrode RX does not have any signal from the common electrode, and therefore the touch sensor under the sensing electrode RX does not have any signal.

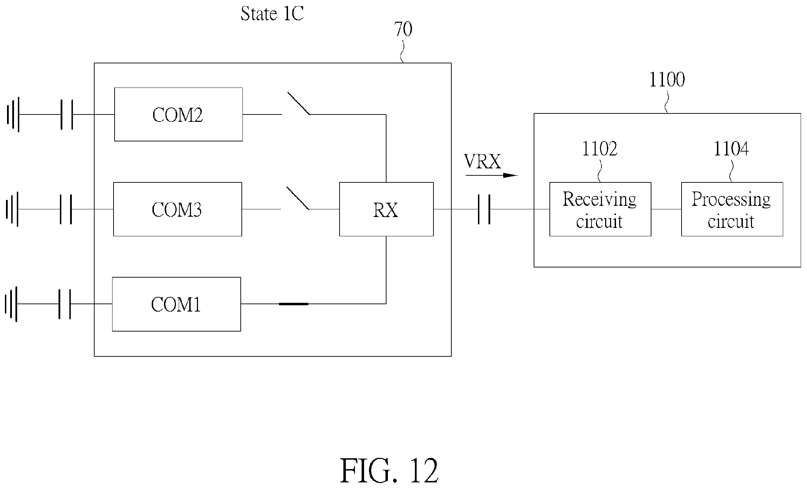

FIG. 12 illustrates the state 1C. The state 1C means that when the knob 70 rotates to a specific angle, the common electrode COM1 is electrically connected to the sensing electrode RX while the common electrode COM2 is not electrically connected to the sensing electrode RX. At this time, the knob 70 is not pressed, so the common electrode COM3 is not electrically connected to the sensing electrode RX. In such a situation, the sensing electrode RX is electrically connected to only 1 common electrode, and the generated signal is weaker.

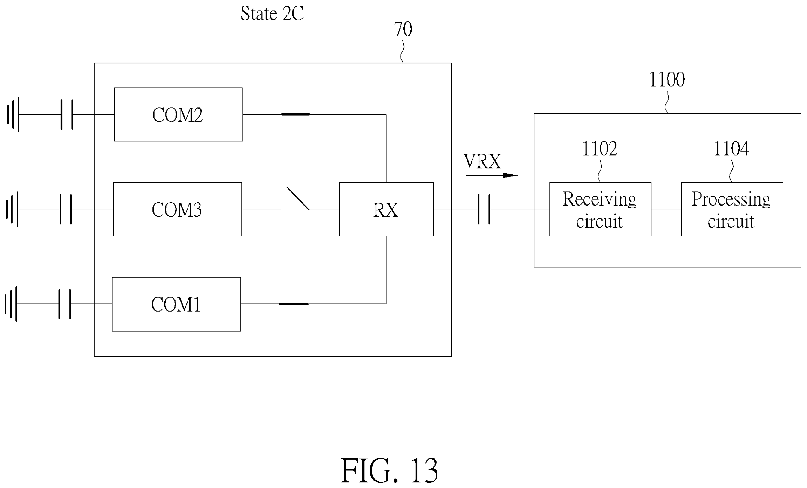

FIG. 13 illustrates the state 2C. The state 2C means that when the knob 70 rotates to a specific angle, the common electrodes COM1 and COM2 are both electrically connected to the sensing electrode RX. At this time, the knob 70 is not pressed, so the common electrode COM3 is not electrically connected to the sensing electrode RX. In such a situation, the sensing electrode RX is electrically connected to 2 common electrodes, and the generated signal is larger (compared with the state 1C).

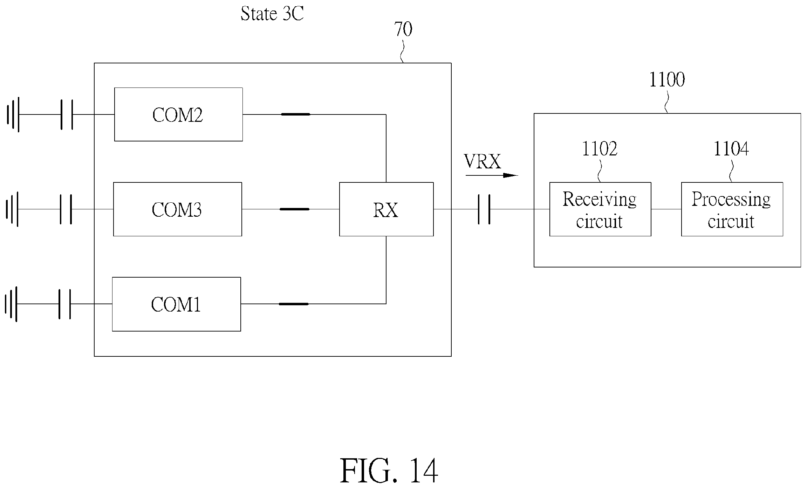

FIG. 14 illustrates the state 3C. The state 3C means that when the knob 70 is pressed, the common electrodes COM1-COM3 are all electrically connected to the sensing electrode RX. In such a situation, the sensing electrode RX is electrically connected to 3 common electrodes, and the generated signal is the maximum.

As a result, by detecting the signal amount, the processing circuit 1104 in the sensing circuit 1100 may determine which state the knob 70 is in, and thereby determine the rotation direction and angle of the knob 70 and determine whether the knob 70 is pressed, to realize various operations of the knob 70 accordingly.

As mentioned above, the sensing circuit 1100 receives the sensing signal VRX from the touch sensor corresponding to the sensing electrode RX, and determines the state of the knob 70 through the signal amount of the sensing signal VRX. Since the detected touch sensor is under the sensing electrode RX and is close to the sensing electrode RX but not electrically connected, the signal on the sensing electrode RX would generate capacitance variations on the touch sensor through capacitance coupling. In addition, the signal on the sensing electrode RX comes from the common electrodes COM1-COM3 that are electrically connected to the sensing electrode RX and applied with a ground voltage. When the number of electrically connected common electrodes is larger, the equivalent capacitance variation produced on the touch sensor under the sensing electrode RX is also larger. When the knob detection is performed, the driving signal output by the sensing circuit 1100 will charge or discharge the capacitors on the touch sensor(s). The current generated during the charging or discharging process is thereby received by the sensing circuit 1100 as the sensing signal VRX.

In an embodiment, the receiving circuit 1102 in the sensing circuit 1100 includes an analog front-end (AFE) circuit, which may be coupled to the touch sensor through a sensing terminal of the chip of the sensing circuit 1100. The current generated by this touch sensor will flow through the sensing terminal to be received by the AFE circuit. For example, the AFE circuit may include a resistor, which is used to convert the current from the touch sensor into the sensing signal VRX in the voltage form, then the back-end analog-to-digital converter (ADC) converts it to the digital form, and then the signal is sent to the processing circuit 1104 to perform determination. Corresponding to different capacitance variations on the touch sensor, the AFE circuit will receive currents or voltages having different magnitudes, so that different currents or voltage may be measured on the sensing terminal of the receiving circuit 1102.

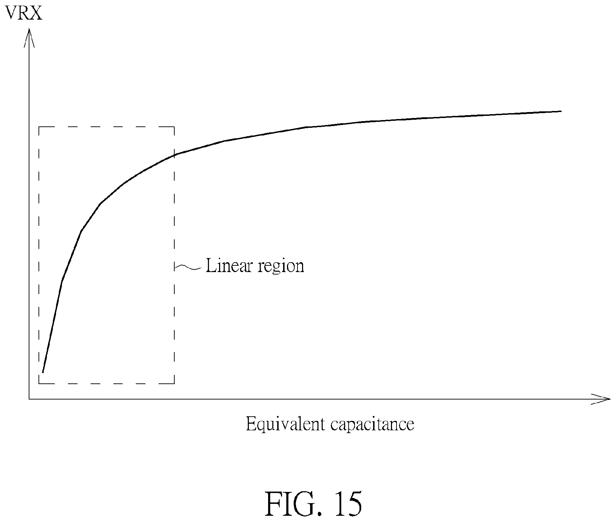

FIG. 15 illustrates the correspondence of the equivalent capacitance and the sensing signal VRX. As mentioned above, the sensing signal VRX on the vertical axis may be a signal in the voltage form or current form. The equivalent capacitance on the horizontal axis corresponds to the number of common electrodes electrically connected to the sensing electrode RX. As shown in FIGs. 11-14, each of the common electrodes COM1-COM3 has a coupling capacitance with the corresponding touch sensor on the panel. When the sensing electrode RX is electrically connected to any of the common electrodes COM1-COM3, the equivalent capacitance detected by the sensing circuit 1100 through the sensing electrode RX is equivalent to the combination of the coupling capacitance of the sensing electrode RX itself and the coupling capacitance corresponding to the connected common electrode(s). In other words, when the sensing electrode RX is electrically connected to more common electrodes, the equivalent capacitance value corresponding to the sensing electrode RX is larger, and the generated sensing signal VRX is also larger. Their correspondence is shown in FIG. 15. Preferably, through well design of the sizes of the sensing electrode RX and the common electrodes COM1-COM3 on the knob, the equivalent capacitance may fall in the linear region, so that the sensing signal VRX detected by the sensing circuit 1100 may effectively reflect the variation of the equivalent capacitance.

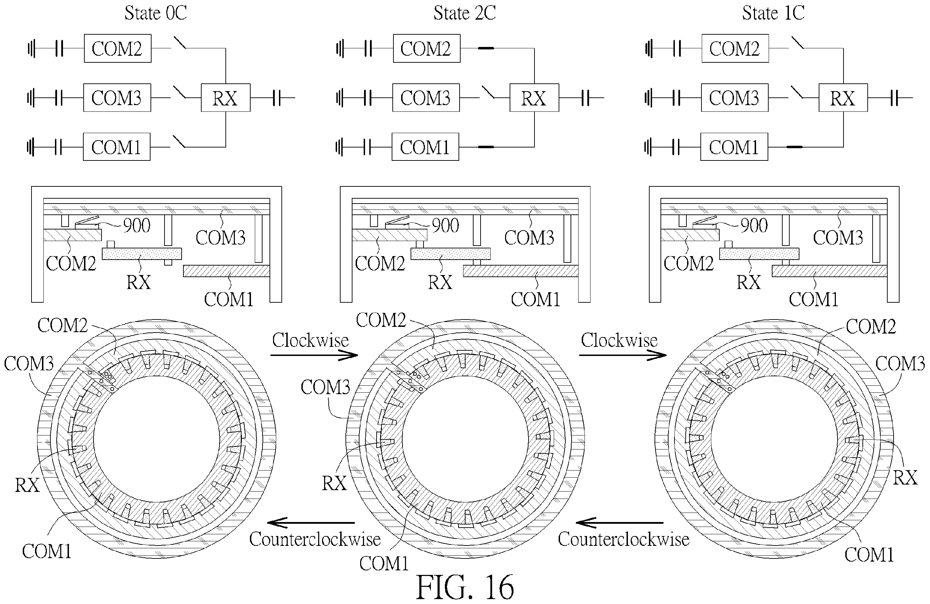

FIG. 16 illustrates the rotation operation of the knob corresponding to different states. In the absence of pressing, the knob may have 3 states: 0C, 1C and 2C, according to the number of common electrodes electrically connected to the sensing electrode RX. As shown in FIG. 16, under the state 0C, the connecting post of the electrode ring of the sensing electrode RX overlaps the sawtooth recessing parts on the electrode rings of the common electrodes COM1 and COM2, so that neither the common electrode COM1 nor the common electrode COM2 is electrically connected to the sensing electrode RX. Under the state 1C, the connecting post of the electrode ring of the sensing electrode RX overlaps the sawtooth protruding part on the electrode ring of the common electrode COM1 and the sawtooth recessing part on the electrode ring of the common electrode COM2, so that only the common electrode COM1 is electrically connected to the sensing electrode RX. Under the state 2C, the connecting post of the electrode ring of the sensing electrode RX overlaps the sawtooth protruding part on the electrode rings of the common electrodes COM1 and COM2, so that the common electrodes COM1 and COM2 are both electrically connected to the sensing electrode RX.

The transition between each state is also shown in FIG. 16. In this embodiment, the electrode rings of the common electrodes COM1 and COM2 rotate with the knob, while the electrode rings of the common electrode COM3 and the sensing electrode RX are fixed. The knob may rotate clockwise or counterclockwise. In the clockwise rotation, the state of the knob changes in the order of 0C, 2C, 1C, 0C, 2C, 1C... etc., and in the counterclockwise rotation, the state of the knob changes in the order of 1C, 2C, 0C, 1C, 2C, 0C... etc. The sensing circuit of the knob may thereby determine its rotation direction and calculate the rotation angle based on the variation and sequence of the knob's state within a period of time.

As can be seen, through the sawtooth structure of the common electrode ring, the protruding or recessing part of the sawtooth may be adjusted to be aligned with the connecting post on the sensing electrode ring when the knob rotates, so as to change the number of common electrodes electrically connected to the sensing electrode RX at any time. Therefore, the sawtooth structure of the common electrode ring should be well designed, in order to realize the variations of different states 0C-2C during the rotation process. In this embodiment, it may be designed that the sawtooth width on the electrode ring of the common electrode COM1 is larger, while the sawtooth width on the electrode ring of the common electrode COM2 is smaller, and each sawtooth on the two electrode rings corresponds to each other and rotates synchronously, so that the state of the knob meets a predetermined change pattern in clockwise or counterclockwise rotation. Note that the above method of using a sawtooth structural design to change electrode coupling during the knob rotation is one of various implementations of the present invention. In other embodiments, as long as the number of common electrodes on the knob electrically connected to the sensing electrode RX may change with the operation of the knob, and the change method may be used to determine the rotation direction and/or angle of the knob, the related knob structure and determination method should belong to the scope of the present invention.

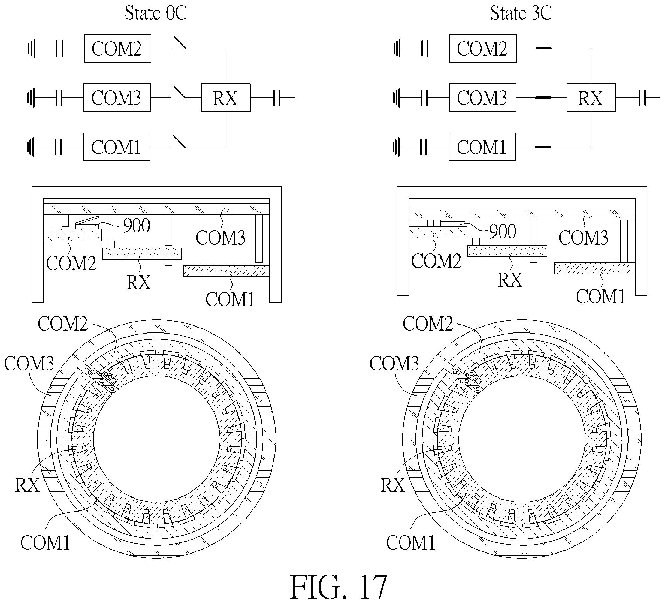

FIG. 17 illustrates the pressing operation of the knob corresponding to different states. As mentioned above, in the absence of pressing, the knob may be in one of the three states 0C-2C, where the state 0C is taken as an example in FIG. 17. When the knob is pressed, the pressing clip 900 is pressed down, so that the common electrodes COM1-COM3 are all electrically connected to the sensing electrode RX. At this time, the knob is in the state 3C. The sensing circuit of the knob may thereby determine whether the knob is pressed according to the state of the knob.

As mentioned above, different states 0C-3C of the knob correspond to the number of common electrodes electrically connected to the sensing electrode RX, which further corresponds to the signal amount on the touch sensor under the sensing electrode RX. The sensing circuit of the knob may determine which state the knob is in according to the magnitude of the signal amount. In an embodiment, the state of the knob may affect the signal distribution of multiple touch sensors near the sensing electrode RX. In order to achieve more accurate determination of the knob state, the algorithm in the processing circuit may refer to the signal distribution of these touch sensors and use appropriate threshold values to determine the state of the knob.

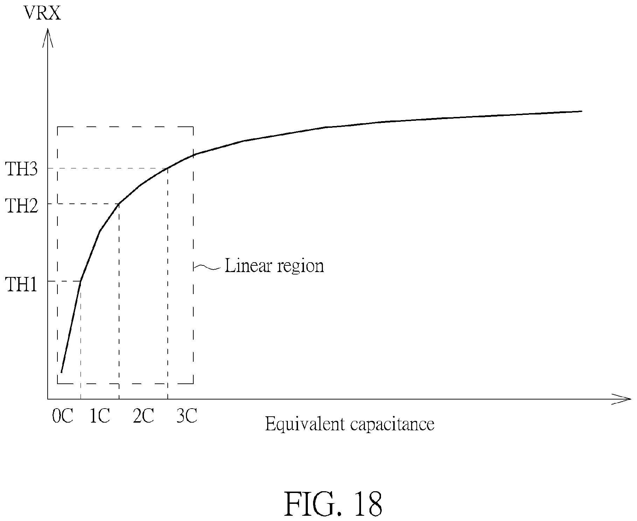

For example, as shown in FIG. 18, in the correspondence of the equivalent capacitance and the sensing signal VRX shown in FIG. 15, the states 0C-3C respectively correspond to different equivalent capacitances and different magnitudes of the sensing signal VRX. In this embodiment, the processing circuit may compare the signal amount of the sensing signal VRX with any threshold value TH1-TH3, to determine which state the knob is in. In detail, when determining that the signal amount of the sensing signal VRX is smaller than the threshold value TH1, the processing circuit may determine that the knob is in the state 0C. When determining that the signal amount of the sensing signal VRX is greater than the threshold value TH1 but smaller than the threshold value TH2, the processing circuit may determine that the knob is in the state 1C. When determining that the signal amount of the sensing signal VRX is greater than the threshold value TH2 but smaller than the threshold value TH3, the processing circuit may determine that the knob is in the state 2C. When determining that the signal amount of the sensing signal VRX is greater than the threshold value TH3, the processing circuit may determine that the knob is in the state 3C.

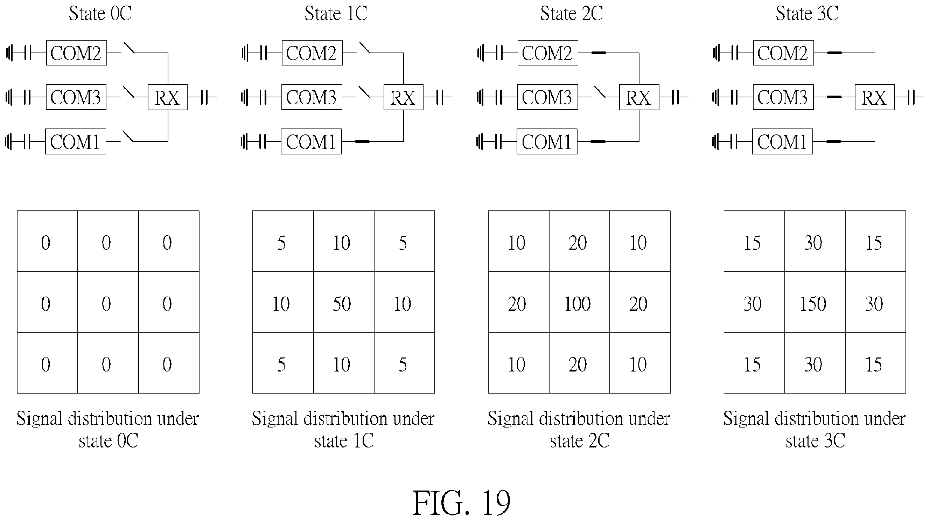

FIG. 19 is a schematic diagram of the signal distribution on the touch sensor corresponding to the sensing electrode RX according to an embodiment of the present invention, where exemplary distributions of signal amount (i.e., signal variation) under the states 0C-3C are shown, where each grid may represent a touch sensor. In detail, the touch sensor located in the middle under the sensing electrode RX has the largest signal amount, of which the values are 0, 50, 100 and 150 in the states 0C-3C, respectively. Therefore, in an embodiment, the threshold values TH1-TH3 used to determine the knob state may be set to 25, 75 and 125, respectively, to distinguish the knob operations in different states. In another embodiment, the signal amounts of multiple touch sensors (such as the 9 touch sensors shown in FIG. 19) that may be affected by the sensing electrode RX are also combined to serve as the sensing signal VRX received by the sensing circuit, with appropriate threshold value settings to realize the determination of the knob operation. Alternatively, the sensing electrode RX may be disposed above multiple touch sensors; that is, the area of the sensing electrode RX covers multiple touch sensors. Therefore, the sensing circuit may obtain the sensing signals VRX of these touch sensors to increase the signal amount and enhance the performance of knob determination.

Note that the present invention aims at providing a knob on a touch panel and a related sensing circuit, where only one sensing electrode needs to be provided on the knob, which may simplify the detection method of the sensing circuit and save the cost of the sensing circuit. Those skilled in the art may make modifications and alterations accordingly. For example, the knob structure shown in FIG. 3 or FIG. 7 is one of various embodiments of the present invention. In another embodiment, the electrode ring in the knob may be disposed in another method. For example, the electrode ring of the common electrode COM3 for pressing detection may be disposed in the inner side. Alternatively, in other embodiments, there may be more than 4 electrode rings included in the knob, and the number of disposed electrode rings is not limited to those described in the present disclosure.

In addition, in the above embodiments, the electrode ring of each electrode is arranged in the horizontal direction along the knob shell, so as to rotate with the rotation of the knob. The structure of the present invention is not limited thereto. In another embodiment, the positions of the electrode rings may also be changed. For example, parts or all of the electrode rings may be designed as an electrode piece vertical to the bottom of the knob. As long as the electrode ring can move or rotate with the rotation of the knob, and thereby change the electrical connection between the sensing electrode and the common electrode under different knob states, the related implementations should fall within the scope of the present invention.

Moreover, in the embodiments of the present invention, the sizes of the sensing electrodes may be designed according to system requirements. For example, if two common electrodes COM1 and COM2 are applied, the common electrodes COM1 and COM2 may be designed to have different sizes to enhance the separation between different states. In a preferable embodiment, in the structure of the knob 70 shown in FIG. 7, the areas of the common electrodes COM1, COM2 and COM3 may be designed to have the ratio 1:2:3, to achieve the optimal knob determination effect.

In addition, in some embodiments, the knob may be disposed on the touch panel, and the sensing circuit of the knob may have both knob detection and touch sensing functions. In other embodiments, the knob may be disposed on a general display panel without the touch function, or on the casing of a general tablet or an electronic device, but not limited thereto. The sensing electrode and common electrode of the knob may also be disposed in any appropriate manner. For example, a sensing electrode piece and a common electrode piece may be attached to a predetermined position on the panel, and the corresponding electrode posts and electrode rings are connected above, and then the shell of the knob is covered on each electrode element. Alternatively, a sensing electrode piece and a common electrode piece may also be attached to the base of the knob, then connected to the electrode post and electrode ring, covered by the shell, and then the entire knob is fitted to the desired position.

Note that in the above embodiment, the sensing circuit may apply a reference voltage to the touch sensor corresponding to the common electrodes; hence, the sensing signals on the sensing electrode may be the signal variations generated by the reference voltage from the common electrode. In another embodiment, the signal variations of the sensing signal may also be generated based on the reference voltage (e.g., the ground voltage) provided by a touch object (such as a finger of the user) operating the knob. In such a situation, the knob may be disposed with a conductor inside, and the conductor may be coupled to the corresponding common electrode inside the knob. Therefore, during the knob operation (e.g., the user turns the knob with fingers), the reference voltage from the touch object may be sent to the common electrode through the conductor, to provide a signal for the sensing electrode when the common electrode is electrically connected to the sensing electrode, so as to generate signal amounts on the touch sensor corresponding to the sensing electrode. In this way, the touch sensor corresponding to the common electrode does not need to further receive a reference voltage, and the reference voltage is provided by the touch object instead. In another embodiment, a reference voltage may be applied to the touch sensor corresponding to the common electrode, and combined with the voltage signal of the conductor to obtain a larger signal amount, thereby improving the performance of knob detection.

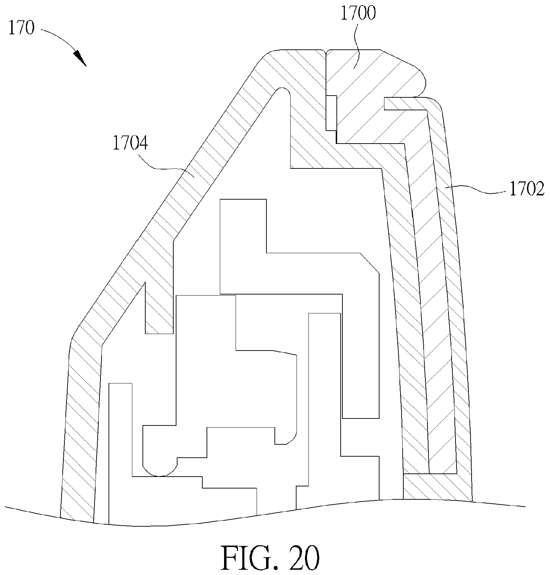

The conductor may be implemented in any appropriate manner. In an embodiment, the conductor may be a conductive ring disposed on the surface of the knob, and the conductive ring may be contacted by the touch object when the touch object is operating the knob. Alternatively, the conductor may be or include a metal layer contained inside the conductor. As shown in FIG. 20, the knob 170 is disposed to have a metal layer 1700 and a rubber layer 1702, and the shell 1704 of the knob may be used to cover and protect the internal electrodes. The metal layer 1700 is a sheet conductor covering the entire bottom of the knob 170 and exposed around the knob 170. This is an easily accessible position when the touch object operates the knob, so the ground voltage from the touch object may be forwarded to the corresponding common electrode. In this embodiment, more signal amounts may be provided for the sensing electrode through the huge parasitic capacitance generated by the large-area sheet conductor of the metal layer 1700.

To sum up, the present invention provides the structure of a knob on a touch panel and a sensing circuit for controlling the knob and a related operation method. Only one sensing electrode needs to be disposed in the knob, and operated with multiple common electrodes to realize various operations of the knob. The sensing circuit only needs to detect and receive the sensing signal through the only one sensing electrode. According to the operations of the knob such as rotation or pressing, the sensing electrode may be electrically connected to different numbers of common electrodes in different states, so as to generate different signal amounts on the touch sensor corresponding to the sensing electrode. Therefore, the sensing circuit may determine various operations of the knob according to the detected signal amount.

## Claims

1. A knob (30) disposed on a touch panel (300), the touch panel (300) comprising a first touch sensor (S1), a second touch sensor (S2) and a third touch sensor (S3), **characterized by** the knob (30) comprising:
a bottom surface, comprising:
a sensing electrode (RX), aligned with the first touch sensor (S1);
a first common electrode (COM1), aligned with the second touch sensor (S2) and receiving a first reference voltage from the second touch sensor (S2); and
a second common electrode (COM2), aligned with the third touch sensor (S3) and receiving a second reference voltage from the third touch sensor (S3); and
a first connector (406, 408) to control the sensing electrode (RX) to be conducted with the first common electrode (COM1) and the second common electrode (COM2) or not when the knob (30) rotates;
wherein a touch sensing circuit (1100) of the touch panel (300) determines a rotation direction of the knob (30) according to a signal variation of the first touch sensor (S1).

2. The knob (30) of claim 1, **characterized in that** the first common electrode (COM1) or the second common electrode (COM2) further receives a third reference voltage from a touch object operating the knob (30), to form the signal variation of the first touch sensor (S1).

3. The knob (30) of claim 2, **characterized by** further comprising:
a conductor, coupled to the first common electrode (COM1) or the second common electrode (COM2), to receive the third reference voltage from the touch object when the touch object operates the knob (30).

4. The knob (30) of claims 1-3, **characterized in that** the first common electrode (COM1) and the second common electrode (COM2) have different sizes.

5. The knob (70) of claims 1-4, **characterized in that** the bottom surface further comprises a third common electrode (COM3), which is electrically connected to the sensing electrode (RX) when the knob (70) is pressed and not electrically connected to the sensing electrode (RX) when the knob (70) is not pressed.

6. The knob (70) of claim 5, **characterized by** comprising:
a second connector (806) to control the sensing electrode (RX) to be conducted with the third common electrode (COM3) or not when the knob (70) is pressed.

7. The knob (30, 70) of claims 1-6, **characterized in that** the knob (30, 70) comprises the only one sensing electrode (RX).

8. The knob (30, 70) of claims 1-7, **characterized in that** at least one of the first reference voltage and the second reference voltage is a ground voltage.

9. The knob (30, 70) of claims 1-8, **characterized in that** the first common electrode (COM1) is coupled to a common electrode ring (412), and the sensing electrode (RX) is coupled to a sensing electrode ring (402), wherein a connecting post (406) is disposed on the sensing electrode ring (402) and electrically connected to the sensing electrode ring (402).

10. The knob (30, 70) of claim 9, **characterized in that** the common electrode ring (412) contacts the connecting post (406) and electrically connects the sensing electrode ring (402) when the knob (30, 70) rotates to a first angle, and the common electrode ring (412) does not contact the connecting post (406) when the knob (30, 70) rotates to a second angle.

11. The knob (30, 70) of claims 9-10, **characterized in that** the sensing electrode ring (402) is fixed on the touch panel (300) and the common electrode ring (412) rotates with the knob (30, 70) when the knob (30, 70) rotates.

12. The knob (30, 70) of claims 9-10, **characterized in that** the common electrode ring (412) is fixed on the touch panel (300) and the sensing electrode ring (402) rotates with the knob (30, 70) when the knob (30, 70) rotates.

13. A sensing circuit (1100), coupled to a knob (30, 70), **characterized by** the sensing circuit (1100) comprising:
a receiving circuit (1102) to receive a signal variation (VRX) from the knob (30, 70); and
a processing circuit (1104), coupled to the receiving circuit (1102), to determine a rotation direction of the knob (30, 70) according to the signal variation (VRX);
wherein the signal variation (VRX) is received through a first touch sensor (S1) aligned with and coupled to a sensing electrode (RX) of the knob (30, 70);
wherein the signal variation (VRX) is generated according to whether the sensing electrode (RX) is conducted with a first common electrode (COM1) and a second common electrode (COM2) in the knob (30, 70).

14. The sensing circuit (1100) of claim 13, **characterized in that** the knob (30, 70) comprises the only one sensing electrode (RX).

15. The sensing circuit (1100) of claims 13-14, **characterized in that** a second touch sensor (S2) corresponding to the first common electrode (COM1) and a third touch sensor (S3) corresponding to the second common electrode (COM2) are applied with a first reference voltage and a second reference voltage, respectively, to generate the signal variation (VRX).

16. The sensing circuit (1100) of claim 15, **characterized in that** at least one of the first reference voltage and the second reference voltage is a ground voltage.

17. The sensing circuit (1100) of claims 15-16, **characterized in that** at least one of the first reference voltage and the second reference voltage is from a touch object operating the knob (30, 70).

18. The sensing circuit (1100) of claims 13-17, **characterized in that** the processing circuit (1104) further determines whether the knob (30, 70) is pressed according to the signal variation (VRX).

## Amended claims

### Amended claims in accordance with Rule 137(2) EPC.

1. A knob (30) disposed on a touch panel (300), the touch panel (300) comprising a first touch sensor (S1), a second touch sensor (S2) and a third touch sensor (S3), **characterized by** the knob (30) comprising:
a bottom surface, comprising:
a sensing electrode (RX), aligned with the first touch sensor (S1);
a first common electrode (COM1), aligned with the second touch sensor (S2) and receiving a first reference voltage from the second touch sensor (S2); and
a second common electrode (COM2), aligned with the third touch sensor (S3) and receiving a second reference voltage from the third touch sensor (S3);
a first connector (406) to control the sensing electrode (RX) to be conducted with the first common electrode (COM1) or not when the knob (30) rotates; and
a second connector (408) to control the sensing electrode (RX) to be conducted with the second common electrode (COM2) or not when the knob (30) rotates;
wherein a touch sensing circuit (1100) of the touch panel (300) determines a rotation direction of the knob (30) according to a signal variation of the first touch sensor (S1).

2. The knob (30) of claim 1, **characterized in that** the first common electrode (COM1) or the second common electrode (COM2) further receives a third reference voltage from a touch object operating the knob (30), to form the signal variation of the first touch sensor (S1).

3. The knob (30) of claim 2, **characterized by** further comprising:
a conductor, coupled to the first common electrode (COM1) or the second common electrode (COM2), to receive the third reference voltage from the touch object when the touch object operates the knob (30).

4. The knob (30) of claims 1-3, **characterized in that** the first common electrode (COM1) and the second common electrode (COM2) have different sizes.

5. The knob (70) of claims 1-4, **characterized in that** the bottom surface further comprises a third common electrode (COM3), which is electrically connected to the sensing electrode (RX) when the knob (70) is pressed and not electrically connected to the sensing electrode (RX) when the knob (70) is not pressed.

6. The knob (70) of claim 5, **characterized by** comprising:
a third connector (806) to control the sensing electrode (RX) to be conducted with the third common electrode (COM3) or not when the knob (70) is pressed.

7. The knob (30, 70) of claims 1-6, **characterized in that** the knob (30, 70) comprises the only one sensing electrode (RX).

8. The knob (30, 70) of claims 1-7, **characterized in that** at least one of the first reference voltage and the second reference voltage is a ground voltage.

9. The knob (30, 70) of claims 1-8, **characterized in that** the first common electrode (COM1) is coupled to a common electrode ring (412), and the sensing electrode (RX) is coupled to a sensing electrode ring (402), wherein a connecting post (406) is disposed on the sensing electrode ring (402) and electrically connected to the sensing electrode ring (402).

10. The knob (30, 70) of claim 9, **characterized in that** the common electrode ring (412) contacts the connecting post (406) and electrically connects the sensing electrode ring (402) when the knob (30, 70) rotates to a first angle, and the common electrode ring (412) does not contact the connecting post (406) when the knob (30, 70) rotates to a second angle.

11. The knob (30, 70) of claims 9-10, **characterized in that** the sensing electrode ring (402) is fixed on the touch panel (300) and the common electrode ring (412) rotates with the knob (30, 70) when the knob (30, 70) rotates.

12. The knob (30, 70) of claims 9-10, **characterized in that** the common electrode ring (412) is fixed on the touch panel (300) and the sensing electrode ring (402) rotates with the knob (30, 70) when the knob (30, 70) rotates.
